Europäisches Patentamt

European Patent Office

Office européen des brevets

(11) Publication number: **0 051 286**
.B1

# EUROPEAN PATENT SPECIFICATION

(45) Date of publication of patent specification: **29.01.86**

(21) Application number: **81109252.7**

(22) Date of filing: **29.10.81**

(51) Int. Cl.⁴: **G 11 B 7/24,** G 11 B 7/26, B 41 M 5/26, B 41 M 5/24, G 03 F 7/02

(54) Process for making an imaging medium solution.

(30) Priority: **31.10.80 US 202837**

(43) Date of publication of application:
**12.05.82 Bulletin 82/19**

(45) Publication of the grant of the patent:
**29.01.86 Bulletin 86/05**

(84) Designated Contracting States:
**AT BE CH DE FR GB IT LI LU NL SE**

(56) References cited:
EP-A-0 003 262
EP-A-0 022 313
GB-A-2 005 457

(73) Proprietor: **DISCOVISION ASSOCIATES**
**3300 Hyland Avenue**
**Costa Mesa California 92626 (US)**

(72) Inventor: **Atwell, David L.**
**21581 Dakar Lane**
**Huntington Beach California, 92646 (US)**
Inventor: **Michalchik, Michael**
**1970 Port Laurent Place**
**Newport Beach California 92660 (US)**

(74) Representative: **Fleuchaus, Leo, Dipl.-Ing. et al**
**Fleuchaus & Wehser Melchiorstrasse 42**
**D-8000 München 71 (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

This invention relates to a method of preparing a solution suitable for use in forming a thin, uniform ablative imaging medium as referred to in the preamble of claim 1.

Imaging media solutions of this type are known by EP—A1—22313 and GB—A—2 005 457 and are of particular use in making video recording discs. The video discs include a thin, light-absorbing recording layer formed from such a solution on a smooth, planar surface of a substrate. The solution is typically poured onto the substrate surface, and the substrate is then spun at a prescribed angular velocity, to evaporate a solvent in the solution and yield a thin film having a prescribed thickness. These solutions are also useful in the formation of micro-lithographic films, and the formation of chemical etch resit-type films used in the manufacture of integrated circuits and the like. The thin layers of films are typically ablated by scanning them with a laser beam or electron beam.

In one particular video disc embodiment as described in the copending application EP—A—51 281 having the same priority date, the recording layer includes a nitrocellulose polymer and a disperse red I dye in prescribed relative portions. Information is recorded in the nitrocellulose recording layer by scanning it with an intensity-modulated beam of light, to selectively energize prescribed portions of the layer and thereby induce spaced explosions in it. This produces a succession of spaced, information-bearing microscopic pits.

The nitrocellulose recording layer·is produced by first forming an imaging medium solution of the nitrocellulose polymer, the dye, and a solvent such as Cellosolve (trademark) acetate. The solution is poured onto a smooth, planar surface of a substrate, after which the substrate is spun at a prescribed angular velocity, to form the thin, uniform film of prescribed thickness. The particular thickness achieved is dependent on the viscosity of the solution and on the spin velocity.

Ideally, the imaging medium coating liquid should be highly absorptive of light at the wavelength of the intensity-modulated beam of light to be used in recording, and should have a prescribed viscosity that is not subject to significant variations, so that the prescribed thickness for the layer can be readily achieved.

Nitrocellulose is a particularly advantageous material for forming such layers because of its mechanical strength and the small amount of energy required to ablate it. However, nitrocellulose is an extremely difficult material to evenly dissolve in a solvent, since it tends to resist diffusion and to clump together in microscopic "lumps" which have a higher viscosity than the surrounding solution. At room temperature, these lumps may resist diffusion for a long time, e.g. several weeks, but will slowly dissolve. Because the lumps are so small, they do not appear in normal viscosity tests of the solution, but can result in irregularities in the layers formed with the material.

It is an object of the invention to find measurement for reducing a drift in viscosity of the unheated solution over a period of weeks. This object is achieved with the steps of the characterizing portion of claim 1.

The heating step of the present invention reduces the time required to dissolve the lumps and thereby stabilizes the viscosity of the imaging medium solution and its eventual value from several weeks to about one hour.

More specifically, in the first two steps of mixing, about 27 grams of dispersed red I dye is mixed with about 3 liters of a suitable solvent such as Cellosolve (trademark) acetate, to produce the dye dispersion and about 150 grams of a mixture of approximately 70% by weight 5-sec nitrocellulose polymer in isopropyl alcohol is mixed with about 6 liters of a solvent such as Cellosolve (trademark) acetate, to form the nitrocellulose solution. Each solution is then filtered to remove foreign particles of size larger than about 0.2 microns. In mixing together the nitrocellulose solution and dye dispersion about 3 liters of Cellosolve (trademark) acetate solvent is added to controllably adjust the viscosity of the imaging medium solution to about 9 centipoise. The specific amount of additional solvent required is dependent on the amount of solid material removed in the steps of filtering and intrinsic viscosity of the nitrocellulose.

Other aspects and advantages of the present invention will become apparent from the following description of the process, which illustrates, by way of example, the principles of the invention.

The composition of the imaging medium solution consists essentially of about 150 parts (by weight) nitrocellulose isopropyl alcohol mixture and about 27 parts disperse red I dye dissolved in an effective amount of a solvent. The nitrocellulose mixture and the dye are thoroughly mixed in the solvent, and the two solutions are mixed together and heated, to form a colloidal solution that has a viscosity of about 9 centipoise and that is highly absorptive of light at a wavelength of about 480 to 490 nanometers. In one embodiment, the nitrocellulose has a nitrogen content of about 12%, and the solvent is Cellosolve (trademark) acetate, in forming a residual dry coating of 2,1% of weight.

As can readily be adapted by those skilled in the art, the dye used can be selected to absorb laser lines at 514 nm, 416 nm, and 632.8 for recording by ablation of a coating layer.

The disperse red I dye is an azo dye and has the chemical formula $C_{16}H_{18}N_4O_3$. Suitable alternative solvents to the Cellosolve (trademark) acetate solvent include amyl acetate, butyl acetate, and Carbitol (trademark), which are all readily commercially available.

The nitrocellulose polymer is normally shipped with a content of nominally 30%, $\pm10\%$ isopropyl alcohol, to reduce flammability hazards. The nitrocellulose preferably has a nitrogen content of about 12%, and has a viscosity measured to be 5 to 6 seconds.

In large quantities, the dye dispersion is prepared by adding 99 ± 0.2 grams of dispersed red I dye to 11 liters of filtered Cellosolve (trademark) acetate solvent, and then mixing the combination for about 30 minutes in a covered stainless steel vessel. The dye dispersion is then sequentially filtered using a pre-filter equivalent to a millipore AP15—124 or number 40 Whatman (trademark) paper, under 0,56 kg/cm$^2$ (8 pounds per square inch) of nitrogen pressure, and using a 0.2 micron final filter equivalent to a millipore FGLP142-50.

The solids content of the filtered dye dispersion is determined using conventional gravimetric techniques. Less than 1.5% of dye loss is expected.

As previously mentioned, the nitrocellulose is supplied containing nominally 30% isopropyl alcohol. Due to settling, evaporation, and raw material variations, however, this percentage can vary substantially. Accordingly, the solids content of each nitrocellulose batch is determined prior to preparation of the nitrocellulose solution. If the solids content is determined to be more or less than 70.0% of the nitrocellulose batch, the specific amount of nitrocellulose to be used in forming the nitrocellulose solution is modified to be proportionately less or more than the specified 550 grams.

The nitrocellulose solution is formed by slowly adding the nitrocellulose polymer isopropyl alcohol mixture to 22 liters of solvent in a stainless steel mixing vessel, with constant agitation. The polymer is added at a rate sufficiently low to avoid settling on the bottom of the vessel. After mixing for one hour, agitation is increased until all the polymer is suspended with gentle stirring.

The resultant nitrocellulose solution is filtered in the same manner as described above for the filtering of the dye solution, and the two filtered solutions are then mixed together.

The vessel containing the mixed solution is then covered, and the temperature of the solution is raised to between 50°C and 60°C, while maintaining the agitation. The solution is maintained at this temperature for at least one hour, after which it is cooled back to room temperature. The cooled solution is then filtered with a 0.2 micron filter equivalent to a millipore FGLP142-50.

The cooled imaging medium solution is then tested, using conventional techniques, for its viscosity, solids content, and transmission at 480 nanometers. If any of these three tests show that the solution is not within a prescribed, satisfactory range, the composition of the solution is controllably adjusted, accordingly.

More particularly, if the viscosity of the imaging medium solution is determined to be greater than 9.0 ± 0.5 centipoise, an appropriate amount of additional filtered solvent is added to lower the viscosity to the correct level. Conversely, if the viscosity is determined to be less than this prescribed range, appropriate additional amounts of the dye dispersion and nitrocellulose polymer solution, in their correct stoichiometric proportions, are added to the solution to raise the viscosity to the correct level.

Similarly, if the solids content of the imaging medium solution is found to be greater than or less than 2.10 ± 0.5%, appropriate additional amounts of filtered solvent or dye dispersion and nitrocellulose solutions are added, to bring the solids contents to the appropriate, expected level. The transmission of a 500:1 dilution of the solution is expected to be 20 ± 1% at 480 nanometers for a 1 cm cell. If the solution is found to be outside this range, appropriate amounts of dye dispersion or nitrocellulose solution and solvent are added, to bring the solution to the correct level.

It will be apparent from the foregoing description that the present invention provides a solution that can be used effectively in forming ablative imaging media such as video discs, microlithographic films, and chemical etch resist-type films. The solution is highly absorptive at a prescribed wavelength, and has highly stabilized viscosity, whereby films of precise, uniform thickness can be formed.

## Claims

1. A method of preparing a solution suitable for use in forming a thin, uniform ablative imaging medium, the method including the steps of: mixing a dye with a solvent to form a dye dispersion, mixing nitrocellulose with a solvent to form a nitrocellulose solution; and combining the dye dispersion with the nitrocellulose solution to form an imaging medium solution; characterized by heating the imaging medium solution to a temperature between about 50°C and 60°C and maintaining the solution at that temperature for at least one hour to stabilize the viscosity of the imaging medium solution.

2. A method as defined in Claim 1, wherein the step of mixing the dye dispersion with the nitrocellulose solution includes a step of adding a prescribed amount of solvent, such that the stabilized viscosity of the imaging medium solution is in the range of 8.5 to 9.5 centipoise at 30°C.

3. A method as defined in Claim 1, wherein: in the first step of mixing, about 27 grams of disperse red I dye is mixed with about three liters of solvent; and in the second step of mixing, about 150 grams of a mixture of approximately 70% nitrocellulose in isopropyl alcohol is mixed with about six liters of solvent.

## Revendications

1. Procédé de préparation d'une solution appropriée pour utilisation dans la formation d'un support de représentation par image ablatif uniforme fin, cette méthode comprenant les étapes de: mélanger un colorant avec un solvant pour former une dispersion de colorant, mélanger de la nitrocellulose avec un solvant pour former une solution de nitrocellulose; et combiner la dispersion de colorant avec la solution de nitrocellulose pour former une solution de support de représentation par image; caractérisé en ce que la solution du support de représentation par image est chauffée à une température entre environ 50°C et 60°C et maintenue à la température pendant au moins une heure pour stabiliser la viscosité de la solution du support de représentation par image.

2. Procédé selon la revendication 1 caractérisé en ce que l'étape de mélange de la dispersion de colorant avec la solution de nitrocellulose comprend une étape d'addition d'une quantité prédéterminée de solvant, telle que la viscosité stabilisée de la solution de support de représentation par image est comprise entre 8,5 et 9,5 centipoises à 30°C.

3. Procédé selon la revendication 1 caractérisé en ce que, dans la première étape de mélange, environ 27 grammes de colorant rouge 1 dispersé est mélangé avec environ trois litres de solvant; et dans la seconde étape de mélange, environ 150 grammes du mélange d'approximativement 70% de nitrocellulose dans de l'alcool isopropylique est mélangé avec environ six litres de solvant.

**Patentansprüche**

1. Verfahren zur Herstellung einer Lösung, die geeignet ist, bei der Erzeugung eines dünnen gleichförmigen abtragbaren Bildaufnahmemediums verwendet zu werden, wobei in dem Verfahren die Schritte enthalten sind: Mischen eines Farbstoffs mit einem Lösungsmittel, um eine Farbstoffdispersion herzustellen, Mischen von Nitrozellulose mit einem Lösungsmittel, um eine Nitrozelluloselösung herzustellen; und Vereinigen der Farbstoffdispersion mit der Nitrozelluloselösung, um die Lösung eines Bildaufnahmemediums herzustellen; gekennzeichnet durch Erhitzen der Lösung des Bildaufnahmemediums auf eine Temperatur zwischen ungefähr 50°C und 60°C und Halten der Lösung bei dieser Temperatur während mindestens einer Stunde, um die Viskosität der Lösung des Bildaufnahmemediums zu stabilisieren.

2. Verfahren nach Anspruch 1, bei dem der Schritt des Mischens der Farbstoffdispersion mit der Nitrozelluloselösung einen Schritt enthält, bei dem eine vorgeschriebene Menge von Lösungsmittel so hinzugegeben wird, daß die stabilisierte Viskosität der Lösung des Bildaufnahmemediums im Bereich von 8,5 bis 9,5 Zentipoise bei 30°C liegt.

3. Verfahren nach Anspruch 1, bei dem im ersten Mischungsschritt ungefähr 27 Gramm disperser Rot I-Farbstoff mit ungefähr drei Liter Lösungsmittel gemischt wird; und im zweiten Mischungsschritt ungefähr 150 Gramm einer Mischung von ungefähr 70% Nitrozellulose in Isopropylalkohol mit ungefähr sechs Liter Lösungsmittel gemischt wird.